# DEMANDE DE BREVET EUROPEEN

(11) **EP 4 668 324 A1**
(43) Date de publication de la demande: **24.12.2025**
(21) Numéro de dépôt: 25182537.8
(22) Date de dépôt: 13.06.2025
(51) Int. Cl.: H01L 21/683

(54) **PROCEDE DE COLLAGE DIRECT DE PUCES**

(30) Priorité: 19.06.2024 FR 2406560
(71) Demandeur: Commissariat à l'Energie Atomique et aux Energies Alternatives, 75015 Paris (FR)
(72) Inventeur: MONTMEAT, Pierre, 38054 GRENOBLE CEDEX 09 (FR); FOURNEL, Franck, 38054 GRENOBLE CEDEX 09 (FR); VACON, Mélanie, 38054 GRENOBLE CEDEX 09 (FR)
(74) Mandataire: Cabinet Beaumont

(57) **Abrégé**

La présente description concerne un procédé de collage de puces (120) comprenant les étapes suivantes :
a) fournir un substrat donneur (100) dans lequel sont formées des puces (120), le substrat donneur (100) comprenant une face avant (101) et une face arrière (102),
b) assembler la face avant (101) du substrat donneur (100) sur un substrat temporaire (200), par collage direct,
c) de préférence, amincir le substrat donneur (100),
d) coller l'ensemble formé du substrat donneur (100) et du substrat temporaire (200) sur un dispositif de manipulation (400) comprenant un support rigide (401) et un film adhésif (402), la face arrière (102) du substrat donneur (100) étant collée sur le film adhésif (402),
e) séparer le substrat temporaire (200) du substrat donneur (100),
f) découper le substrat donneur (100) de manière à singulariser les puces (120),
g) coller les puces (120) sur le substrat receveur (300) par collage direct.

## Description

### Domaine technique

La présente description concerne de façon générale le domaine de la microélectronique, et plus particulièrement, les procédés de collage de puces électroniques.

### Technique antérieure

En microélectronique, le collage direct permet d'assembler des composants qui ont été préparés individuellement sur des supports différents. Par exemple, il est possible de fabriquer des puces sur un substrat donneur puis de les coller sur un substrat récepteur.

Le collage direct est un collage spontané qui n'utilise pas de matériau adhésif liquide. Il est généralement exécuté à température ambiante même **s'il** est possible de coller des surfaces chaudes. Il est, en général, exécuté à pression ambiante mais il est possible de le faire sous vide. Comme c'est un collage spontané, il n'y a pas besoin d'exercer une force sur les deux surfaces que l'on souhaite coller. Une légère pression locale peut néanmoins être utilisée pour amorcer le collage depuis un point précis. Le collage se propage ensuite de lui-même le long des surfaces avec une onde de collage.

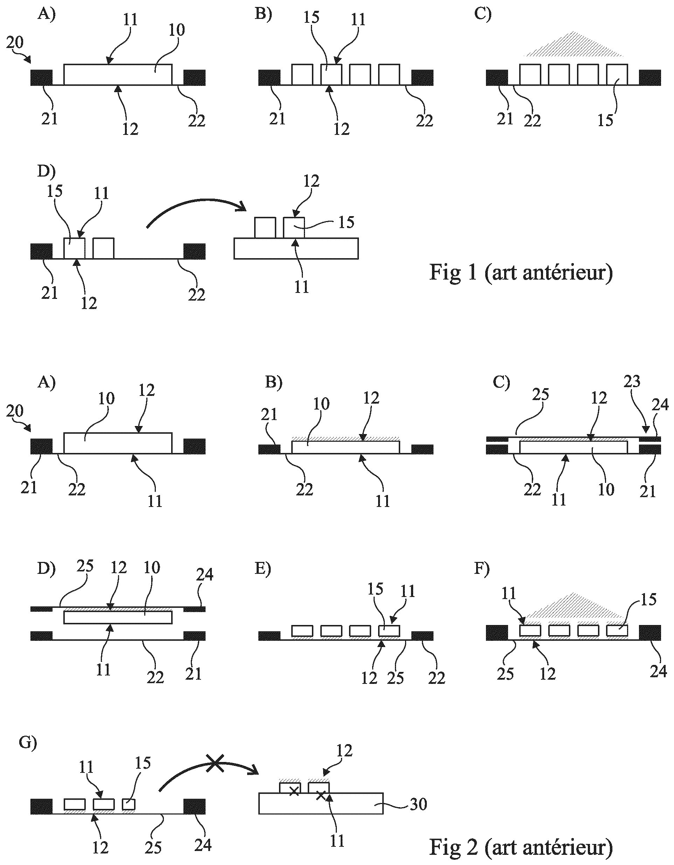

Typiquement, un procédé de collage direct de puces comprend les étapes suivantes (figure 1 vues A) à D)):
- coller un substrat donneur 10, dans lequel sont formées des puces 15, sur un dispositif de manipulation 20 comprenant un cadre rigide 21 et un ruban adhésif 22, la face arrière 12 du substrat 10 étant collée au ruban adhésif 22, la face 11 avant du substrat donneur 10 étant accessible (figure 1 vue A)),
- découper le substrat donneur 10 entre les puces 15 pour les singulariser (figure 1 vue B)),
- nettoyer la face avant 11 des puces 15 (figure 1 vue C)),
- coller la face 11 avant des puces 15 sur un substrat receveur 30 (figure 1 vue D)).

L'étape de nettoyage de la face avant des puces est essentielle puisque le collage direct est très exigeant vis-à-vis de l'état de propreté de la surface à coller. Celle-ci doit présenter la plus faible contamination organique et particulaire. Il est, par exemple, possible de la nettoyer par une combinaison de plasmas et de solutions aqueuses qui peuvent être associées ou non à des ondes sonores. La libération des puces est ensuite possible, après insolation du ruban adhésif avec des UV. Un tel procédé est, par exemple, décrit dans les travaux de Sanchez et al. (« Chip to wafer direct bonding technologies for high density 3D integration », 2012, IEEE 62nd Electronic Components and Technology Conference, 1960-1964 et « Collective Die Direct Bonding for Photonic on Silicon », 2018, ECS Trans., 86, 5, 223).

Les substrats en silicium dans lesquels sont formés les puces ont généralement des épaisseurs comprises entre 500 et 700 µm. Or, pour certaines applications, il est nécessaire de coller des puces très fines (typiquement dont l'épaisseur est inférieure à 200 µm). Il est donc nécessaire d'amincir le substrat. L'amincissement du substrat donneur peut être effectué par abrasion (ou rodage) au moyen de roues diamantées. Si cette technique permet d'obtenir des épaisseurs très homogènes, elle augmente la rugosité de la face avant du substrat. Pour un substrat en silicium, la rugosité RMS de la face avant peut dépasser 100 nm, ce qui n'est pas compatible avec un collage direct pour lequel la rugosité doit être inférieure à 0,5 nm. Il n'est pas non plus possible d'aplanir la face avant facilement car la configuration d'une plaque collée sur ruban adhésif n'est pas compatible avec un polissage mécano-chimique.

De plus, pour de telles épaisseurs, la plaque fine n'est plus suffisamment rigide pour être manipulée sans précaution.

Une solution serait d'utiliser une étape de report pour amincir la face arrière du substrat donneur selon les étapes suivantes (figure 2 vues A) à G)):
- coller un substrat donneur 10, dans lequel sont formées des puces 15, sur un premier dispositif de manipulation 20 comprenant un cadre rigide 21 et un ruban adhésif 22, la face avant 11 du substrat donneur 10 étant collée au ruban adhésif et la face arrière 12 du substrat donneur 10 étant accessible (figure 2 vue A)),
- amincir la face arrière 12 du substrat donneur 10 (figure 2 vue B)),
- coller le substrat donneur 10 sur un deuxième dispositif de manipulation 23 comprenant un cadre rigide 24 et un ruban adhésif 25, la face arrière 12 du substrat donneur 10 étant collée au ruban adhésif 25 (figure 2 vue C)),
- séparer le substrat donneur 10 du premier dispositif de manipulation 20 , par exemple par insolation du ruban adhésif 22 (figure 2 vue D)),
- découper le substrat donneur 10 pour singulariser les puces 15 (figure 2 vue E)),
- nettoyer la face avant 11 des puces 15 (figure 2 vue F)),
- coller la face avant 11 des puces sur un substrat receveur 30 (figure 2 vue G)).

Cependant, la face avant 11 des puces 15 a été en contact avec la colle du ruban adhésif 22 du premier dispositif de manipulation, ce qui rend très difficile son nettoyage. La mauvaise qualité de surface conduit à de nombreux défauts de collage. Un tel procédé est encore plus problématique pour un collage direct hybride avec une surface comprenant du cuivre et d'oxyde de silicium car le cuivre est à nu depuis le début du procédé.

### Résumé de l'invention

Il existe un besoin d'avoir un procédé de collage de puces, le collage devant présenter peu ou pas de défaut, le procédé devant pouvoir être mis en œuvre pour des puces de faibles épaisseurs (typiquement pour des épaisseurs inférieures à 300 µm, voire inférieures à 100 µm ou 50µm).

Ce but est atteint par un procédé de collage de puces sur un substrat receveur comprenant les étapes suivantes :
a) fournir un substrat donneur dans lequel sont formées des puces, le substrat donneur comprenant une première surface en face avant et une deuxième surface en face arrière,
b) assembler la première surface du substrat donneur sur un substrat temporaire, par collage direct,
c) de préférence, amincir le substrat donneur depuis la deuxième surface,
d) coller l'ensemble formé du substrat donneur et du substrat temporaire sur un dispositif de manipulation comprenant un support rigide et un film adhésif, la deuxième surface du substrat donneur étant collée sur le film adhésif,
e) séparer le substrat temporaire du substrat donneur,
f) découper le substrat donneur de manière à singulariser les puces,
g) coller les puces sur le substrat receveur par collage direct.

Selon un mode de réalisation particulier, l'étape f) est réalisée entre l'étape b) et l'étape d).

Selon un mode de réalisation particulier, lors de l'étape b), la première surface du substrat donneur est recouverte par une couche de protection.

Selon un mode de réalisation particulier, la couche de protection est une couche de carbone amorphe, une couche de silicium ou une couche de polymère, par exemple une couche d'acrylate ou d'un de ses dérivés.

Selon un mode de réalisation particulier, la première surface du substrat donneur est une surface comprenant de l'oxyde de silicium et du cuivre.

Selon un mode de réalisation particulier, la première surface du substrat donneur est une surface en silicium, en germanium, en un matériau III/V, tel que l'AsGa, l'InP ou un matériau II/VI, tel que CdHgTe.

Selon un mode de réalisation particulier, une étape de détourage du substrat donneur est réalisée avant l'étape b) ou après l'étape b).

Selon un mode de réalisation particulier, les puces ont une surface comprise entre 0,5 x 0,5 mm² et 20 x 20 mm².

Selon un mode de réalisation particulier, les puces ont une épaisseur inférieure à 300µm, de préférence inférieure à 100 µm, encore plus préférentiellement inférieure à 50µm.

Selon un mode de réalisation particulier, l'étape f) est réalisée par gravure plasma.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 vues A), B), C), D), précédemment décrite, représente de manière schématique, différentes étapes d'un procédé de collage de puces selon l'art antérieur;
la figure 2 vues A), B), C), D), E), F), G), précédemment décrite, représente de manière schématique, différentes étapes d'un autre procédé de collage de puces selon l'art antérieur;
la figure 3A, la figure 3B, la figure 3C, la figure 3D, la figure 3E, la figure 3F, la figure 3G et la figure 3H, représentent de manière schématique, différentes étapes d'un procédé de collage de puces selon un mode de réalisation particulier de l'invention ;
la figure 4A, la figure 4B, la figure 4C, la figure 4D, la figure 4E, la figure 4F, la figure 4G et la figure 4H représentent de manière schématique, différentes étapes d'un procédé de collage de puces selon un autre mode de réalisation particulier de l'invention ; et
la figure 5A, la figure 5B, la figure 5C, la figure 5D, la figure 5E, la figure 5F, la figure 5G et la figure 5H représentent de manière schématique, différentes étapes d'un procédé de collage de puces selon un autre mode de réalisation particulier de l'invention.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 %, de préférence à 5 %.

Par compris entre X et Y, on entend que les bornes X et Y sont incluses.

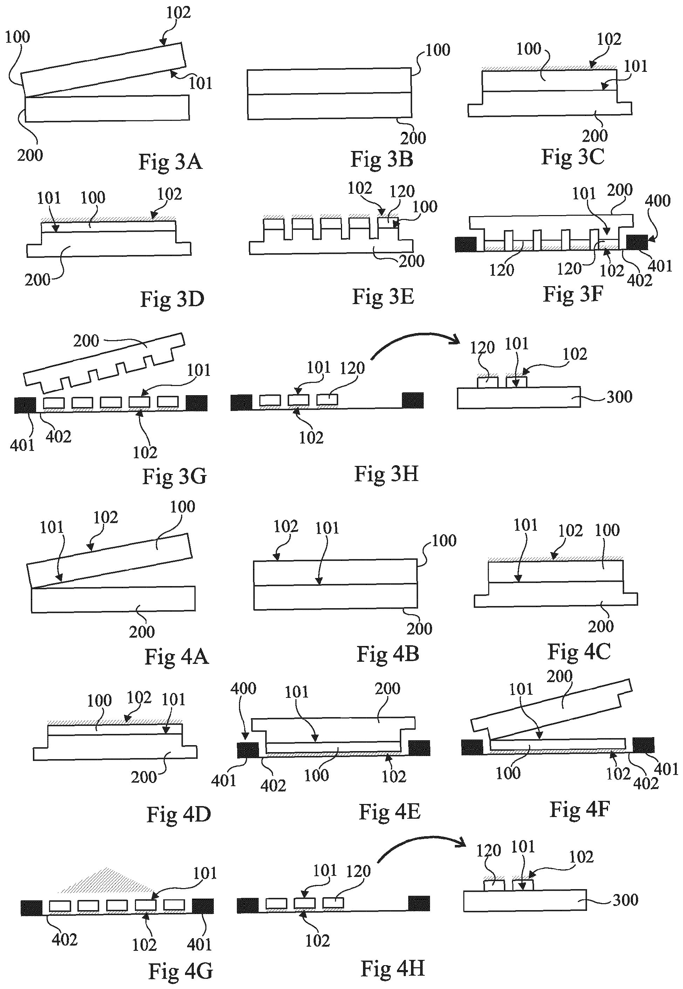

Nous allons maintenant décrire plus en détail le procédé de collage de puces en faisant référence aux figures 3A à 3H, 4A à 4H et 5A à 5H annexées.

Le procédé comprend les étapes suivantes :
a) fournir un substrat donneur 100 dans lequel sont formées des puces, le substrat donneur 100 comprenant une première surface 101 en face avant et une deuxième surface 102 en face arrière (figures 3A, 4A, 5A),
b) assembler la première surface 101 du substrat donneur 100 sur un substrat temporaire 200, par collage direct (figures 3B, 4B, 5B),
c) de préférence, amincir le substrat donneur 100 depuis la deuxième surface (figures 3D, 4D, 5D),
d) coller l'ensemble formé du substrat donneur 100 et du substrat temporaire 200 sur un dispositif de manipulation 400 comprenant un support rigide 401 et un film adhésif 402, la deuxième surface 102 du substrat donneur 100 étant collée sur le film adhésif 402 (figures 3F, 4E, 5E),
e) séparer le substrat temporaire 200 du substrat donneur 100 (figures 3G, 4F, 5F),
f) découper le substrat donneur 100 de manière à singulariser les puces 120 (figures 3E, 4G, 5G),
g) coller les puces 120 sur le substrat receveur 300 par collage direct (figures 3H, 4H, 5H).

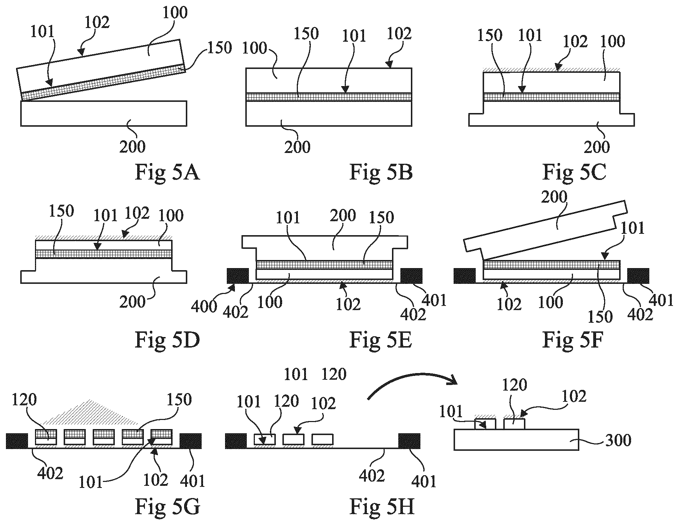

Selon un premier mode de réalisation, les différentes étapes peuvent être réalisées dans l'ordre a), b), c), d), e), f) et g) comme par exemple représenté sur les figures 4A à 4H et sur les figures 5A à 5H.

Selon un deuxième mode de réalisation, les différentes étapes peuvent être réalisées dans l'ordre a), b), c), f), d) e) et f) comme par exemple représenté sur les figures 3A à 3H.

La mise en œuvre d'un collage direct, pour assembler le substrat donneur 100 avec le substrat temporaire 200, permet de protéger la surface en face avant 101 du substrat donneur 100 et donc des puces 102 pendant les étapes d'amincissement et/ou de découpe. Une fois les puces 120 amincies, découpées et séparées du substrat temporaire 200, celles-ci peuvent être collées sur le substrat receveur 300 par un autre collage direct. Lors d'un tel procédé, les puces 120 et la face avant du substrat donneur 100 n'est pas en contact avec le film adhésif 402. La surface avant 101 des puces étant propre et peu rugueuse, le collage obtenu présente peu ou pas de défaut.

Préalablement à l'étape a), il est possible de réaliser un ou plusieurs pré-traitements sur le substrat donneur 100 et/ou sur le substrat temporaire 200 de façon à les rendre compatible avec un collage direct.

Le prétraitement peut être choisi parmi les pré-traitements suivants : recuit thermique, plasma, polissage et nettoyage humide.

A titre d'exemple, il est possible de former une couche d'oxyde à la surface du substrat temporaire 200 et/ou de réaliser une étape de polissage sur le substrat temporaire 200 et/ou sur le substrat donneur 100 pour obtenir une rugosité compatible avec un collage direct (typiquement une rugosité inférieure à 0,5 nm RMS). Il est possible de mettre en œuvre des procédés qui combinent, par exemple, un plasma et une solution aqueuse, notamment un plasma oxygène suivi d'un nettoyage humide CARO (mélange de H₂SO₄, H₂O₂) associé avec SC1 (mélange de H₂O, NH₃, H₂O₂). Il est aussi possible de rendre la surface du substrat temporaire 200 hydrophobe avec une solution à base de HF si le substrat 200 est en silicium par exemple.

Le substrat donneur 100, fourni à l'étape a), comprend une première surface 101 (ou première surface principale) en face avant et une deuxième surface 102 (ou deuxième surface principale) en face arrière. La première surface 101 et la deuxième surface 102 sont parallèles entre elles. La première surface 101 en face avant correspond à la surface que l'on souhaite préparer pour le collage direct avec le substrat receveur 300.

Au moment de l'étape a), des puces 120 ont déjà été formées dans le substrat donneur 100. Les puces 120 sont positionnées du côté de la face avant du substrat donneur 100. Les puces, après la singularisation, auront une épaisseur comprise entre quelques microns et l'épaisseur totale des plaques (sans amincissement). Les puces ont une surface, par exemple, comprise entre 0.5 X 0.5 mm² et 20 X 20 mm².

Le substrat donneur 100 est, par exemple, une plaque. La plaque peut avoir un diamètre compris entre 25 mm et 300 mm, de préférence entre 100 mm et 300mm.

Le substrat donneur 100 peut être un substrat massif 110 en matériau semi-conducteur.

Le substrat donneur 100 est, par exemple, en silicium, en germanium, en un matériau III/V, tel que l'AsGa, l'InP ou un matériau II/VI, tel que CdHgTe.

Le substrat donneur 100 peut comprendre un substrat support recouvert, en face avant, par une couche mince diélectrique, en particulier une couche d'oxyde (oxyde de silicium notamment) . La couche mince d'oxyde peut être formée, par exemple, par dépôt.

Le substrat donneur 100 peut être un substrat SOI ('Silicon on Insulator'), c'est-à-dire un substrat comprenant un substrat support recouvert successivement par une fine couche d'oxyde enterré et une couche de silicium. Il peut s'agir d'un substrat BSOI ('Bonded Silicon On Insulator') comprenant un film de silicium et une couche d'oxyde de silicium.

La première surface du substrat donneur 100 peut être une surface de matériau semiconducteur ou une surface d'oxyde, par exemple une surface d'oxyde de silicium.

Selon un mode de réalisation particulier, la première surface 101 du substrat donneur 100 peut être une surface hybride, formée de plusieurs matériaux (au moins deux matériaux). De préférence, il s'agit d'une couche hybride Cu/SiO₂ comprenant une matrice en oxyde de silicium dans laquelle ont été formés des parties (plots) de cuivre. Les plots de cuivre ont par exemple de 2 µm de côté. De tels plots peuvent être formés par un procédé Damascène.

La première surface 101 du substrat donneur 100 peut être une surface sur laquelle ont été réalisés des dispositifs de microélectronique comme des CMOS ('Complementary metal-oxide-semiconductor'), des niveaux d'interconnexion et des niveaux de collage hybride.

Selon une variante de réalisation représentée sur les figures 5 a à 5H, la première surface 101 du substrat donneur 100 peut être recouverte par une couche de protection 150.

Selon un mode de réalisation préféré, la couche de protection 150 peut être collée par collage direct sur le substrat donneur 100. Ceci permet d'avoir un contact intime entre la couche de protection 150 et le substrat donneur 100.

Ce mode de réalisation peut être réalisé selon les étapes suivantes :
i) coller sur le substrat donneur 100, un substrat de transfert comprenant un support et la couche de protection 150,
ii) retirer le support du substrat de transfert, de manière à former un ensemble comprenant le substrat donneur 100 recouvert par la couche de protection 150.

Selon un autre mode de réalisation, la couche de protection 150 peut être déposée sur le substrat donneur 100.

La couche de polymère peut avoir une épaisseur comprise entre 20 et 50nm.

La couche de protection 150 peut être une couche de silicium, une couche de carbone amorphe ou une couche de polymère par exemple.

Le polymère est, par exemple, un acrylate ou un de ses dérivés, par exemple un acrylate ayant des groupements adamantane, notamment du BARC. La couche de polymère peut avoir, par exemple, une épaisseur de 32 nm.

Le substrat temporaire 200 (ou substrat poignée) peut être formé d'un substrat massif. Par exemple, il s'agit d'une plaque pouvant avoir un diamètre compris entre 25 et 300 mm, de préférence entre 100 mm et 300 mm. Le substrat temporaire 200 doit avoir la même taille que le substrat donneur 100.

Le substrat temporaire 200 est, par exemple, en silicium, en germanium, en un matériau III/V, tel que l'AsGa, l'InP ou un matériau II/VI, tel que CdHgTe.

Le substrat temporaire 200 peut comprendre un substrat support recouvert par une couche mince diélectrique. En particulier, la couche mince est une couche d'oxyde, par exemple une couche d'oxyde de silicium.

Le substrat temporaire 200 peut être un substrat SOI.

Lors de l'étape b), le substrat donneur 100 et le substrat temporaire 200 sont mis en contact pour être assemblés par collage direct.

Il est possible de réaliser un collage hydrophobe, par exemple, en utilisant un substrat donneur 100 dont la première surface 101 est en silicium et un substrat temporaire 200 dont la surface à coller est en silicium.

Il est aussi possible de réaliser un collage hydrophobe-hydrophile avec un substrat 200 en silicium passivé par des liaisons hydrogènes et un substrat 100 dont la surface 101 est une surface hybride avec du cuivre à nu. Avec une surface hydrophobe impliquée dans le collage, la quantité d'eau est limitée, ce qui est particulièrement intéressant pour les surfaces sensibles comme les surfaces hybrides avec du cuivre à nu.

Il est également possible de réaliser un collage hydrophile, par exemple, avec deux surfaces en oxyde, notamment en oxyde de silicium. Les substrats 100, 200 à coller comprennent, par exemple, un substrat support en silicium recouvert par une couche mince d'oxyde en face avant.

On pourra aussi choisir, par exemple, un substrat donneur 100 dont la surface en face avant 101 est une surface hybride, notamment une surface comprenant des plots de cuivre dans une matrice SiO₂ et un substrat temporaire 200 ayant une surface en silicium, par exemple un substrat de type SOI.

Le collage direct peut être réalisé à la pression atmosphérique (soit 1013,25 hPa) ou sous vide.

L'assemblage n'a pas forcément besoin d'être consolidé par un traitement thermique. Néanmoins, un recuit, à une température de préférence inférieure à 200°C, peut être avantageusement réalisé.

L'étape de recuit permet de renforcer l'adhérence. Cette adhérence est, de préférence, inférieure à 1 J/m² de façon à garantir le démontage du substrat temporaire 200 en fin de procédé. L'adhérence peut être évaluée, par exemple, par la méthode de Maszara (J. Appl. Phys. 64, 1988, 10).

Dans le cas d'un collage direct hydrophile qui met en jeu une surface d'oxyde de silicium, la température de recuit sera, de préférence, inférieure à 150°C.

Une étape de détourage du substrat donneur 100 peut être réalisée avant ou après l'étape de collage (étape b), par exemple entre l'étape b) et c) ou après c) (figures 3C, 4C, 5C).

L'étape de détourage peut être réalisée, par exemple, par photolithographie/gravure, ou encore par détourage mécanique au moyen d'une scie diamantée. La largeur du détourage est comprise, par exemple, entre 1 et 5 mm. La profondeur du détourage sera choisie en fonction de l'épaisseur finale du substrat donneur 100. Le détourage permet de s'affranchir de la fragilité du bord des plaques amincies pendant l'amincissement.

Une étape d'amincissement est, avantageusement, réalisée (étape c). L'amincissement est réalisé depuis la face arrière du substrat donneur 100 jusqu'à l'épaisseur désirée, par exemple, par abrasion/rodage et/ou par gravure chimique et /ou polissage mécano-chimique (CMP).

L'étape d'amincissement peut être effectuée en plusieurs sous-étapes. Il est possible de combiner une méthode d'abrasion mécanique avec des méthodes de gravure chimique. Dans ce cas, le substrat donneur 100 peut comprendre une couche d'arrêt de gravure. Le substrat donneur 100 peut être aminci jusqu'à une épaisseur de l'ordre du micromètre. Comme le substrat donneur 100 est parfaitement tenu par le collage direct sur le substrat temporaire 200, il peut être manipulé naturellement par toutes les machines de micro-électronique.

Après l'étape d'amincissement, des étapes de nettoyage peuvent être réalisées pour limiter la contamination particulaire, notamment en vue du démontage final. Avantageusement, ce nettoyage peut utiliser les machines classiques de la micro-électronique ce qui facilite et optimise cette étape.

En fonction des épaisseurs de puces 120 désirées, l'étape d'amincissement peut ne pas être réalisée.

Lors de l'étape d), l'ensemble formé du substrat donneur 100 et du substrat temporaire 200 est collé sur un dispositif de manipulation 400 comprenant un cadre rigide 401 et un film adhésif 402. La deuxième surface 102 du substrat donneur 100 est collé sur le ruban adhésif 402 (autrement dit, la face arrière du substrat donneur 100 est collée).

Dans le cas, très avantageux, où les puces 120 sont découpées avant de séparer le substrat temporaire 200 du substrat donneur 100 (autrement dit, dans le cas où l'étape f) est réalisée avant l'étape d), comme représenté sur les figures 3A à 3H), l'ensemble formé du substrat donneur 100 découpé et du substrat temporaire est collé sur le dispositif de manipulation 400.

L'adhérence entre le substrat donneur 100 (découpé ou non découpé) et le ruban adhésif 102 est très forte (typiquement supérieure à 20 J/m²). L'adhérence entre le substrat donneur 100 et le ruban adhésif 102 est ainsi supérieure à l'adhérence entre le substrat temporaire 200 et le substrat donneur 100 (inférieure à 1 J/m²).

Ainsi, lors de l'étape e), il est possible de décoller mécaniquement le substrat donneur 100 du substrat temporaire 200. On obtient ainsi une surface directement compatible avec un collage direct ('ready to bond'). Le démontage mécanique peut être réalisé au moyen d'une lame ou d'un coin. En insérant un coin/une petite lame entre le substrat temporaire 200 et le substrat donneur 100, on démonte l'interface la plus faible, c'est-à-dire l'interface entre le substrat temporaire 100 et le substrat donneur 200.

Il est possible d'utiliser des machines automatiques de démontage bien connue des technologies de collage temporaire. Par exemple, les machines de la société EVG qui utilisent un anneau pour encercler et soulever le substrat temporaire. Une petite lame/coin peut être utilisée pour initier le décollement. Par exemple, les machines de la société Tazmo utilisent aussi une lame pour amorcer le décollement. La face arrière du substrat temporaire 200 est clampée par du vide sur une table aspirante, et la surface se déforme de façon à propager le décollement.

Après le démontage, on obtient des puces 120 déjà singularisées et dont la première surface 101 en face avant est directement compatible avec un collage direct.

Lors de l'étape f), les puces 120 sont séparées les unes des autres au moyen d'une méthode de découpe/gravure. Cette étape peut être réalisée au moyen d'une scie diamantée, d'un laser, par 'stealth dicing' ou par gravure plasma par exemple (notamment avec le procédé Bosch). La gravure plasma peut s'effectuer dans une machine standard de gravure profonde car les puces à singulariser sont maintenues par le substrat temporaire 200 ou par le film adhésif 402. De plus, la gravure plasma permet de préserver le substrat temporaire 200 si celui-ci est encore collé au substrat donneur 100 au moment de la mise en œuvre de cette étape. Comme les puces 120 ne sont pas maintenues par un cadre métallique, il n'y a, avantageusement, pas besoin d'avoir une machine de gravure plasma dédiée. Il est aussi possible d'utiliser un laser d'ablation nanoseconde ou mieux picoseconde.

Comme représenté sur les figures 4A à 4H et 5A à 5H, les puces 120 peuvent être découpés après la séparation du substrat temporaire 200 du substrat donneur 100.

Si la face avant des puces n'est pas protégée lors de l'étape de découpe (figures 4A à 4H), elle peut être contaminée par des particules issues de l'étape de découpe. On réalisera alors un nettoyage des puces avant de mettre en œuvre l'étape g).

Comme indiqué précédemment, il est possible de déposer une couche de protection 150 sur le substrat donneur 100. Après l'étape f), la couche de protection 150 est retirée avant le collage final des puces 120 sur le substrat receveur 300 (figure 5G). Alternativement, il est possible de retirer la couche de protection 150 avant l'étape f).

La couche de protection 150 peut être retirée, par exemple, par un traitement UV-ozone ou au moyen d'une solution, notamment une solution d'hydroxyde de tétraméthylammonium (TMAH).

Lors de l'étape g), les puces découpées, éventuellement amincies et/ou éventuellement nettoyées peuvent être collées sur le substrat receveur 300.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

### Exemples illustratifs et non limitatifs

Dans les exemples 1 à 6 suivants, des plaques de silicium de 200 mm de diamètre ont été utilisées. L'exemple 7 est réalisé sur des plaques de 100 mm de diamètre.

### Exemple 1

Sur une plaque de silicium de 725 µm, on réalise un dépôt d'oxyde de silicium de 500 nm d'épaisseur. Cette plaque subit un procédé de polissage mécano-chimique de façon à la rendre compatible avec un procédé de collage direct hydrophile. On obtient ainsi un substrat donneur 100 prêt à être collé.

Une seconde plaque de silicium de 725 µm d'épaisseur est nettoyée de façon à la rendre compatible avec un procédé de collage direct hydrophile. On obtient ainsi un substrat temporaire 200 prêt à être collé.

On assemble les substrats 100 et 200 par collage direct. On vient amincir le substrat donneur 100 jusqu'à obtenir une épaisseur de 300 µm par abrasion mécanique au moyen d'une roue diamantée. Puis, on découpe le substrat donneur 100 à la scie diamantée pour former des puces de 10 x 10 mm². La profondeur du trait de découpe est de 310 µm de façon à assurer la découpe complète du substrat donneur 100. La découpe pénètre dans le substrat temporaire 200 sur une faible profondeur (10 µm).

On fixe ensuite la structure obtenue sur un cadre rigide au moyen d'un ruban adhésif Furukawa SP5207M-425. La face amincie du substrat donneur 100 est collée sur le ruban. En insérant un coin dans le collage, on sépare la poignée 200 du substrat donneur 100. On obtient des puces 120 de silicium 10 x 10 mm² d'une épaisseur de 300 µm compatibles avec un procédé de collage direct.

### Exemple 2 :

Le substrat donneur 100 est une plaque de silicium de 725 µm, sur laquelle on réalise un dépôt d'oxyde de silicium de 500 nm d'épaisseur. Cette plaque subit un procédé de polissage mécano-chimique de façon à la rendre compatible avec un procédé de collage direct.

Le substrat temporaire 200 est une seconde plaque de silicium de 725 µm d'épaisseur, nettoyée de façon à la rendre compatible avec un procédé de collage direct hydrophile.

On assemble le substrat donneur 100 et le substrat temporaire 200 par collage direct. Cet assemblage est recuit 2h à 150°C. On vient ensuite amincir le substrat donneur 100 jusqu'à une épaisseur de 200 µm par abrasion mécanique au moyen d'une roue diamantée. Sur le substrat donneur 100 aminci, on effectue un détourage à la scie diamantée d'une largeur de 1,5 mm et d'une profondeur de 220 µm. Le substrat donneur 100 est ensuite aminci par abrasion à une épaisseur de 50 µm. On réalise ensuite un nettoyage particulaire au moyen d'une Megpie^{®} de la société Prosys et d'une solution à 1% d'ammoniaque diluée.

Cette structure est ensuite fixée sur un cadre rigide au moyen d'un ruban adhésif Furukawa SP5207M-425. La face amincie du substrat donneur 100 est collée sur le ruban. En insérant un coin dans le collage, on démonte la poignée 200. Sur le substrat donneur 100, on découpe à la scie diamantée des puces de 5 x 5 mm². On obtient des puces de 5 x 5 mm² d'une épaisseur de 50 µm compatibles avec un procédé de collage direct hydrophile après un nettoyage à base d'ozone et une Megpie utilisant une solution d'ammoniaque à 1%.

### Exemple 3 :

Sur un substrat BSOI de silicium de 725 µm qui se compose d'un film de silicium de 50 µm et d'une couche d'oxyde de silicium de 400 nm, on réalise une oxydation de façon à former un film d'oxyde de silicium de 50 nm. On obtient un substrat donneur 100.

Une seconde plaque de silicium de 725 µm d'épaisseur subit une oxydation de façon à former un film d'oxyde de silicium de 100 nm en surface. On obtient ainsi un substrat temporaire 200. Les substrats 100 et 200 sont nettoyés de façon à les rendre compatibles avec un procédé de collage direct hydrophile.

On assemble les substrats 100 et 200 par collage direct. Cet assemblage est recuit 2h à 150°C. On vient ensuite amincir le substrat donneur 100 jusqu'à 200 µm par abrasion mécanique au moyen d'une roue diamantée. Sur le substrat donneur 100 aminci, on effectue un détourage à la scie diamanté d'une largeur de 1,5 mm et d'une profondeur de 220 µm. Le substrat donneur 100 est ensuite aminci par abrasion à une épaisseur de 100 µm. On grave enfin le silicium restant par une solution aqueuse de HF/HNO₃ avec une solution HF à 10 % et une solution de HNO₃ à 70 %. La gravure s'arrête sur la couche d'oxyde de silicium de 400 nm en le consommant légèrement. Cette couche d'oxyde peut être complètement retirée à l'aide de HF. Sur le substrat donneur 100, on découpe à la scie diamantée des puces de 1 x 12 mm². La profondeur du trait de découpe est de 60 µm de façon à assurer la découpe complète du substrat donneur 100. La découpe pénètre dans le substrat temporaire 200 sur une profondeur réduite à 10 µm.

On fixe cette structure sur un cadre rigide au moyen d'un ruban adhésif Furukawa SP5207M-425. La face amincie du substrat donneur 100 est collée sur le ruban. En insérant un coin dans le collage, on démonte la poignée 200. On obtient des puces de silicium de 1 x 12 mm² d'une épaisseur de 50 µm compatibles avec un procédé de collage direct hydrophile après un nettoyage à base d'ozone et une Megpie utilisant une solution d'ammoniaque à 1%.

### Exemple 4 :

Sur une plaque de silicium, on réalise par un procédé damascène des plots de cuivres de 2 µm de côté dans une matrice SiO₂. Cette plaque subit un détourage à la scie diamantée de 1,5 mm de largeur et 220 µm de profondeur. On réalise ensuite un nettoyage puis un polissage mécano-chimique de façon rendre le substrat donneur 100 compatible avec un procédé de collage direct hydrophile.

Sur un substrat temporaire 200 on dépose par dépôt chimique en phase vapeur 1 µm de SiO₂. On réalise un polissage mécano-chimique du substrat temporaire 200. On assemble le substrat donneur 100 et le substrat temporaire 200 par collage direct. On vient amincir le substrat donneur 100 à 200 µm par abrasion mécanique. Sur le substrat donneur 100, on découpe à la scie diamantée des puces de 3 x 3 mm². La profondeur du trait de découpe est de 210 µm de façon à assurer la découpe complète du substrat donneur 100. La découpe pénètre dans le substrat temporaire 200 sur une profondeur réduite à 10 µm.

On fixe cette structure sur un cadre rigide au moyen d'un ruban adhésif Adwill D-650. La face amincie du substrat donneur 100 est collée sur le ruban. En insérant un coin dans le collage, on démonte la poignée 200. On obtient des puces de silicium de 3 x 3 mm² et d'une épaisseur de 200 µm dont la surface se compose de plots de cuivre de 2 µm de côté. Cette surface est compatible avec un procédé de collage direct hydrophile. On peut rajouter un nettoyage à base d'ozone et une Megpie utilisant une solution d'EKC PCMP 5650 diluée à 1 pour 20 dans de l'eau DI.

### Exemple 5 :

Sur un substrat BSOI (substrat donneur 100) de silicium de 725 µm qui se compose d'un film de silicium de 50 µm et d'une couche d'oxyde de silicium de 400 nm. On réalise par un procédé damascène des plots de cuivres de 2 µm de côté dans une matrice SiO₂.

Une seconde plaque de silicium (substrat temporaire 200) de 725 µm d'épaisseur subie un nettoyage à base de HF de façon à avoir une surface hydrophobe passivée par des liaisons hydrogènes Si-H.

On assemble les substrats 100, 200 par collage direct. On vient ensuite amincir le substrat donneur 100 à 200 µm par abrasion mécanique au moyen d'une roue diamantée. Sur le substrat donneur 100 aminci, on effectue un détourage à la scie diamantée d'une largeur de 1,5 mm et d'une profondeur de 220 µm. On grave enfin le silicium restant par une solution aqueuse de HF/HNO₃. La gravure s'arrête sur la couche d'oxyde de silicium de 400 nm. Avec une étape de photolithographie et une gravure ionique, on vient graver l'oxyde de 400 nm pour ouvrir les chemins de découpe. On retire la résine de lithographie et une gravure plasma par le procédé Bosch permet de singulariser les puces en gravant les 50 µm de silicium. La gravure plasma s'arrête dans la couche d'oxyde des structures damascène. On utilise une gravure ionique avec un plasma de CHF₃ avec 20% de CH₄ à 10 torr et 1500 W pour graver cet oxyde en s'arrêtant sur le silicium de la poignée 200. On obtient des puces de silicium de 50 µm collées à la poignée 200.

On fixe cette structure sur un cadre rigide au moyen d'un ruban adhésif Furukawa SP5207M-425. La face amincie du substrat donneur 100 est collée sur le ruban. En insérant un coin dans le collage, on démonte la poignée 200. On obtient des puces de silicium de 6 X 6 mm² d'une épaisseur de 50 µm compatibles avec un procédé de collage direct hydrophile hybride après un nettoyage à base d'ozone et une Megpie utilisant une solution d'EKC PCMP 5650 dilué à 1 pour 20 dans de l'eau DI.

### Exemple 6 :

Sur une plaque de silicium (substrat donneur 100), on réalise par un procédé damascène des plots de cuivres de 2 µm de côté dans une matrice SiO₂. Cette plaque subit un détourage à la scie diamantée de 1,5 mm de largeur et 220 µm de profondeur. On réalise ensuite un nettoyage puis un polissage mécano-chimique de façon à la rendre compatible avec un procédé de collage direct hydrophile. Juste avant le collage, on réalise ensuite un dépôt de carbone amorphe de 30 nm d'épaisseur.

Sur un substrat temporaire 200, on forme par dépôt chimique en phase vapeur 1 µm de SiO₂. On réalise un polissage mécano-chimique du substrat. Juste avant le collage, on réalise ensuite un dépôt de carbone amorphe de 30nm d'épaisseur.

On assemble les substrats 100, 200 par collage direct. On vient amincir le substrat donneur 100 jusqu'à une épaisseur de 200 µm par abrasion mécanique. Sur le substrat donneur 100, on découpe à la scie diamantée des puces de 3 x 3 mm². La profondeur du trait de découpe est de 210 µm de façon à assurer la découpe complète du substrat donneur 100. La découpe pénètre dans le substrat temporaire 200 sur une profondeur réduite à 10 µm.

On fixe cette structure sur un cadre rigide au moyen d'un ruban adhésif Adwill D-650. La face amincie du substrat donneur 100 est collée sur le ruban. En insérant un coin dans le collage, on démonte la poignée 200. On obtient des puces de silicium de 3 x 3 mm² et d'une épaisseur de 200 µm dont la surface se compose de plots de cuivre de 2 µm de côté. On retire la couche de carbone amorphe par un traitement UV/Ozone de 120 s (à 21 mW/cm² avec une lampe à Mercure basse pression en quartz ayant une longueur d'onde de 254nm et 185nm) qui ne perturbe pas la surface hydride et surtout le cuivre sous-jacent. Cette surface est compatible avec un procédé de collage direct hydrophile. On peut rajouter un nettoyage à base d'ozone et une Megpie utilisant une solution d'EKC PCMP 5650 dilué à 1 pour 20 dans de l'eau DI.

### Exemple 7 :

Sur une plaque de 100 mm de diamètre et de 650 µm d'épaisseur en InP (substrat donneur 100), on effectue un nettoyage à base d'UV-Ozone et de Megpie avec une solution avec d'ammoniaque à 2% pour rendre cette surface compatible avec un collage direct. Sur cette surface, on dépose un nitrure de silicium de 20 nm et un oxyde de silicium à base de TEOS à 300 °C de 20 nm, suivie d'un dépôt de silicium amorphe de 100 nm. Une CMP sur cette couche de silicium amorphe permet de la rendre compatible avec un collage direct. Un traitement avec une solution de HF 1% permet de rendre cette surface hydrophobe en passivant la surface de silicium par des liaisons hydrogènes Si-H.

Une plaque de silicium (substrat temporaire 200) de 525 µm d'épaisseur et de 100 mm de diamètre subit un nettoyage de façon à la rendre compatible avec un procédé de collage direct et un traitement HF permet de la rendre hydrophobe.

On assemble les substrats 100, 200 par collage direct hydrophobe. Cet assemblage est recuit 2H à 100°C. On vient ensuite amincir le substrat donneur 100 à 200 µm par abrasion mécanique au moyen d'une roue diamantée. On dépose ensuite un oxyde TEOS de 400nm. Avec une étape de photolithographie et une gravure ionique, on vient graver l'oxyde de 400 nm pour ouvrir les chemins de découpe. On retire la résine de lithographie et une gravure plasma permet de singulariser les puces en gravant les 200 µm d'InP. La gravure plasma s'arrête dans la couche d'oxyde du substrat donneur 100. On grave ensuite cette couche d'oxyde et la couche de silicium amorphe du substrat donneur 100 avec des plasmas adaptés standards. On obtient des puces d'InP de 200 µm collées à la poignée 200.

On fixe cette structure sur un cadre rigide au moyen d'un ruban adhésif Furukawa SP5207M-425. La face amincie du substrat donneur 100 est collée sur le ruban. En insérant un coin dans le collage, on démonte la poignée 200. On obtient des puces d'InP de 3 x 3 mm² d'une épaisseur de 200 µm. Avec une machine de gravure profonde de silicium compatible avec les cadres métalliques, on grave le silicium en surface des puces. Après un traitement UV/Ozone et une Megpie avec une solution d'ammoniaque à 1% rendant la surface des puces compatibles avec un procédé de collage direct hydrophile.

## Revendications

1. Procédé de collage de puces (120) sur un substrat receveur (300) comprenant les étapes suivantes :
a) fournir un substrat donneur (100) dans lequel sont formées des puces (120), le substrat donneur (100) comprenant une première surface (101) en face avant et une deuxième surface (102) en face arrière,
b) assembler la première surface (101) du substrat donneur (100) sur un substrat temporaire (200), par collage direct,
c) de préférence, amincir le substrat donneur (100) depuis la deuxième surface (102),
d) coller l'ensemble formé du substrat donneur (100) et du substrat temporaire (200) sur un dispositif de manipulation (400) comprenant un support rigide (401) et un film adhésif (402), la deuxième surface (102) du substrat donneur (100) étant collée sur le film adhésif (402),
**l'adhérence** entre le substrat donneur (100) et le film adhésif (402) étant supérieure à l'adhérence entre le substrat temporaire (200) et le substrat donneur (100),
e) séparer le substrat temporaire (200) du substrat donneur (100) par démontage de l'interface entre le substrat temporaire (100) et le substrat donneur (200), moyennant quoi la première surface (101) en face avant est directement compatible avec un collage direct,
f) découper le substrat donneur (100) de manière à singulariser les puces (120),
g) coller les puces (120) sur le substrat receveur (300) par collage direct.

2. Procédé selon la revendication 1, dans lequel l'étape f) est réalisée entre l'étape b) et l'étape d).

3. Procédé selon l'une des revendications précédentes, dans lequel, lors de l'étape b), la première surface (101) du substrat donneur (100) est recouverte par une couche de protection (150).

4. Procédé selon la revendication précédente, dans lequel la couche de protection (150) est une couche de carbone amorphe, une couche de silicium ou une couche de polymère, par exemple une couche d'acrylate ou d'un de ses dérivés.

5. Procédé selon l'une des revendications 1 à 4, dans lequel la première surface (101) du substrat donneur (100) est une surface comprenant de l'oxyde de silicium et du cuivre.

6. Procédé selon l'une des revendications 1 à 4, dans lequel la première surface (101) du substrat donneur (100) est une surface en silicium, en germanium, en un matériau III/V, tel que l'AsGa, l'InP ou un matériau II/VI, tel que CdHgTe.

7. Procédé selon l'une des revendications précédentes, dans lequel une étape de détourage du substrat donneur (100) est réalisée avant l'étape b) ou après l'étape b).

8. Procédé selon l'une des revendications précédentes, dans lequel les puces (120) ont une surface comprise entre 0,5 x 0,5 mm² et 20 x 20 mm².

9. Procédé selon l'une des revendications précédentes, dans lequel les puces (120) ont une épaisseur inférieure à 300µm, de préférence inférieure à 100 µm, encore plus préférentiellement inférieure à 50µm.

10. Procédé selon l'une des revendications précédentes, dans lequel l'étape f) est réalisée par gravure plasma.

11. Procédé selon l'une des revendications précédentes, dans lequel l'étape e) est réalisée en insérant un coin ou une lame entre le substrat temporaire (200) et le substrat donneur (100).
